# EUROPÄISCHE PATENTSCHRIFT

(11) **EP 0 365 767 B1**
(45) Veröffentlichungstag und Bekanntmachung des Hinweises auf die Patenterteilung: **19.05.1993**
(21) Anmeldenummer: 89114379.4
(22) Anmeldetag: 03.08.1989
(51) Int. Cl.: C25D 17/00, C25D 17/28

(54) **Galvanisiereinrichtung für plattenförmige Werkstücke, insbesondere Leiterplatten**
Electroplating apparatus for planar work pieces, particularly circuit boards
Appareil pour le revêtement électrolytique de pièces en forme de plaque, notamment de cartes de circuits imprimés

(30) Priorität: 01.09.1988 DE 3829763
(43) Veröffentlichungstag der Anmeldung: 02.05.1990
(73) Patentinhaber: Siemens Nixdorf Informationssysteme Aktiengesellschaft, 33102 Paderborn (DE)
(72) Erfinder: Hosten, Daniel, B-8120 Handzame (Kortemark) (BE)
(74) Vertreter: Fuchs, Franz-Josef, Dr.-Ing.

(56) Entgegenhaltungen:
- EP-A- 0 254 962
- US-A- 4 048 043

## Beschreibung

Die Erfindung betrifft eine Galvanisiereinrichtung für im horizontalen Durchlauf zu behandelnde plattenförmige Werkstücke, insbesondere Leiterplatten, mit mindestens einem seitlich der Durchlaufbahn angeordneten endlosen Trieb, welcher die Seitenränder der Werkstücke erfassende und in Durchlaufrichtung verfahrbare Transport- und Kontaktierorgane trägt.

Eine derartige Galvanisiereinrichtung ist aus der EP-A-0 254 962 bekannt. Bei der dort beschriebenen Galvanisiereinrichtung sind als Transport- und Kontaktierorgane zangenförmige Kontaktklemmen vorgesehen, welche auf einer endlos umlaufenden Kette oder einem endlos umlaufenden Zahnriemen befestigt sind und die Seitenränder der Werkstücke erfassen. Neben der kathodischen Kontaktierung der Werkstücke dienen diese zangenförmigen Kontaktklemmen gleichzeitig auch als Mitnehmer einer Transporteinrichtung für den horizontalen Durchlauf der Werkstücke. Dabei sind zu Beginn und Ende des Transportweges der plattenförmigen Werkstücke Mittel vorgesehen, die ein Ergreifen des Seitenrandes der Werkstücke durch die Kontaktklemmen, bzw. das Freigeben der Werkstücke durch die Kontaktklemmen bewirken. Durch eine seitlich sich in Durchlaufrichtung erstreckende und an dem jeweiligen Werkstück federnd anliegende Dichtung werden die Kontaktklemmen vor dem Zutritt von Elektrolytlösung abgeschirmt.

Der Erfindung liegt die Aufgabe zugrunde bei einer gattungsgemäßen Galvanisiereinrichtung den baulichen Aufwand für die kathodische Kontaktierung und den Transport der plattenförmigen Werkstücke weiter zu verrringern.

Zur Lösung dieser Aufgabe ist vorgesehen, daß die Transport-und Kontaktierorgane an einem endlos umlaufenden flexiblen Metallband befestigt sind, dessen den Werkstücken zugewandte Seitenflächen oberhalb und unterhalb der Transport- und Kontaktierorgane auf sich in Durchlaufrichtung erstreckenden Führungs- und Abdichtelementen gleitet, wobei die Führungs- und Abdichtelemente in eine Seitenwand der Galvanisierzelle integriert sind.

Bei der erfindungsgemäßen Galvanisiereinrichtung übernimmt das endlos umlaufende flexible Metallband neben den Funktionen als Transporteinrichtung der Werkstücke und als Kontaktiervorrichtung der Werkstücke zusätzlich auch noch die Funktion als Abdichtung der Galvanisierzelle. Durch diese zusätzliche Abdichtfunktion des Metallbandes kann auf die bisher üblichen statischen Abdichtungen verzichtet werden, so daß sich insgesamt eine sehr einfache und wirtschaftliche Konstruktion ergibt. Ein weiterer wesentlicher Vorteil der erfindungsgemäßen Galvanisiereinrichtung ist darin zu erblicken, daß bereits in einem geringen Abstand von ca. 10 mm vom Rand der plattenförmigen Werkstücke die angestrebte Metallschichtdicke erzielt werden kann.

Gemäß einer bevorzugten Ausgestaltung der Erfindung ist vorgesehen, daß zu beiden Seiten der Durchlaufbahn jeweils mindestens ein endloser Trieb angeordnet ist. Hierdurch ergibt sich ein wesentlich sichererer Transport der plattenförmigen Werkstücke durch die Galvanisierlösung, eine erheblich verbesserte kathodische Kontaktierung der Werkstücke und zusätzlich noch eine beidseitige Abdichtung der Galvanisierzelle.

Ist in das Metallband eine Transportperforation eingebracht, so können der Antrieb und die Führung des endlosen Metallbandes in bewährter Weise wie bei Filmbändern und dergleichen vorgenommen werden.

Weiterhin hat es sich als vorteilhaft erwiesen, wenn das Metallband aus Titan besteht. Neben seiner hohen Korrosionsbeständigkeit zeichnet sich Titan auch noch durch seine hohe Flexibilität aus, die einen dauerhaften Einsatz als endloser Trieb ermöglicht.

Gemäß einer bevorzugten Ausgestaltung der erfindungsgemäßen Galvanisiereinrichtung ist vorgesehen, daß als Transport- und Kontaktierorgane mehrere im Abstand zueinander am Metallband befestigte Kontaktfederpaare vorgesehen sind, deren einander gegenüberliegende Kontaktfedern federnd die Seitenränder der Werkstücke zwischen sich aufnehmen. Derartige paarweise angeordnete Kontaktfedern gewährleisten eine sichere kathodische Kontaktierung der Werkstücke und einen sicheren Transport der Werkstücke durch die Galvanisierlösung. Mittel, die ein Ergreifen des Seitenrandes der Werkstücke bzw. das Freigeben der Werkstücke bewirken sollen, sind beim Einsatz der paarweise angeordneten Kontaktfedern nicht erforderlich.

Für die Zufuhr des Kathodenstroms zu dem Metallband hat es sich als vorteilhaft erwiesen, wenn auf der den Werkstücken gegenüberliegenden Seite des Metallbandes eine Stromschiene angeordnet ist, die Kontaktmittel zur Schleifkontaktierung des Metallbandes trägt. Als Kontaktmittel zur Schleifkontaktierung des Metallbandes können dabei Blattfedern oder Bürsten eingesetzt werden. Außerdem hat es sich als günstig erweisen, wenn die Stromschiene aus einem titanummantelten Kupferleiter besteht, da hier der Kupferleiter sehr hohe Ströme leiten kann, während die Titanummantelung eine hohe Korrosionsbeständigkeit der Stromschiene gewährleistet.

Gemäß einer weiteren bevorzugten Ausgestaltung der Erfindung ist vorgesehen, daß die Transport- und Kontaktierorgane durch eine auf der Innenseite der Stirnwand angeordnete Isolierwand abgeschirmt werden. Durch eine derartige Isolierwand können unerwünschte Metallabscheidungen auf den Transport- und Kontaktierorganen zumindest weitgehend verhindert werden.

Ein Ausführungsbeispiel der Erfindung ist in der Zeichnung dargestellt und wird im folgenden näher beschrieben.

Es zeigen
- Fig. 1: in perspektivischer Darstellung einen Teil einer Galvanisiereinrichtung für im horizontalen Durchlauf zu galvanisierende Leiterplatten und
- Fig. 2: die schematische Anordnung der endlos umlaufenden Metallbänder, die bei der in Fig. 1 aufgezeigten Galvanisiereinrichtung als Träger für die mit den Leiterplatten verfahrbaren Transport- und Kontaktierorgane dienen.

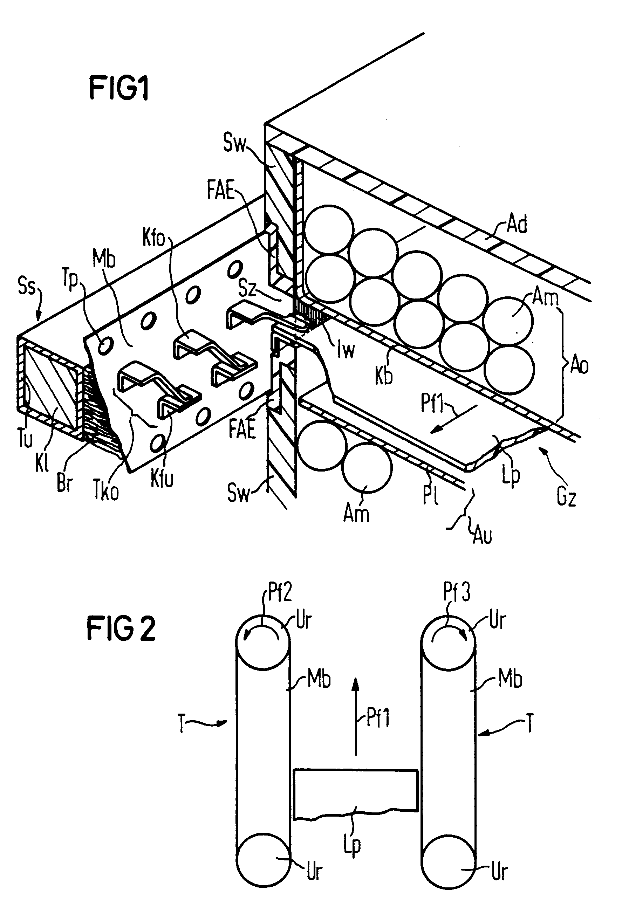

Fig. 1 zeigt eine insgesamt mit Gz bezeichnete Galvanisierzelle, welche eine nicht näher erkennbare Elektrolytlösung aufnimmt und durch welche Leiterplatten Lp in horizontaler Lage in Richtung des Pfeiles Pf1 transportiert werden. In geringem Abstand oberhalb der durch den Pfeil Pf1 aufgezeigten Durchlaufbahn der Leiterplatten Lp befindet sich eine horizontal ausgerichtete obere Anode Ao, die aus einem Korb Kb aus Streckmetall und darin enthaltenem kugelförmigen Anodenmaterial Am besteht. In geringem Abstand unterhalb der Durchlaufbahn befindet sich eine ebenfalls horizontal ausgerichtete untere Anode Au, von welcher in Fig. 1 eine siebförmige Platte Pl aus Streckmetall und das darunter befindliche Anodenmaterial Am zu erkennen sind.

Von der Galvanisierzelle Gz sind eine obere Abdeckung Ad und eine Seitenwand Sw zu erkennen, die in Höhe der Durchlaufbahn der Leiterplatten Lp mit einem durchgehenden horizontalen Schlitz Sz versehen ist. Im Bereich dieses Schlitzes Sz ist oberhalb und unterhalb der Durchlaufbahn jeweils ein sich in Durchlaufrichtung Pf1 erstreckendes, im Querschnitt L-förmiges Führungs- und Abdichtelement FAE in die Seitenwand Sw integriert. Auf den vertikalen Schenkeln der beispielsweise aus hochmolekularem Polyäthylen bestehenden Führungs- und Abdichtelemente FAE gleitet ein im Querschnitt rechteckförmiges Metallband MB, welches dadurch einerseits geführt wird und andererseits den Schlitz Sz abdichtet und den Austritt von Elektrolytlösung aus der Galvanisierzelle Sz verhindert.

Fig. 2 zeigt, daß das vorstehend erwähnte Metallband Mb über zwei Umlenkrollen Ur geführt ist und einen endlosen Trieb T bildet. In Fig. 2 ist ferner zu erkennen, daß zu beiden Seiten der Durchlaufbahn Pf1 der Leiterplatten Lp jeweils ein endloser Trieb T angeordnet ist und daß jeweils eine Umlenkrolle Ur in Richtung der Pfeile Pf2 bzw. Pf3 angetrieben ist. Die Antriebsrichtung der inneren Trume der endlosen Triebe T entspricht dabei der Durchlaufrichtung Pf1 der Leiterplatten Lp.

Fig. 1 zeigt, daß das Metallband Mb oben und unten jeweils mit einer Transportperforation Tp versehen ist und in Längsrichtung im Abstand zueinander angeorndete Transport- und Kontaktierorgane TKO trägt. Die jeweils aus einer oberen Kontaktfeder Kfo und einer unteren Kontaktfeder Kfu bestehenden Transport- und Kontaktierorgane TKO nehmen die Seitenränder der Leiterplatten Lp im Bereich der Schlitze Sz federnd zwischen sich auf, d.h. sie dienen als Mitnehmer für den Transport der Leiterplatten Lp durch die Galvanisierzelle Gz. Die Transport- und Kontaktierorgane TKO ermöglichen aber auch gleichzeitig eine sichere kathodische Kontaktierung der Leiterplatten Lp, wobei der Kathodenstrom der Rückseite des Metallbandes Mb über eine ortsfeste Stromschiene Ss und eine daran befestigte Bürste Br zugeführt wird. Die Stromschiene Ss besteht aus einem massiven Kupferleiter Kl, der durch eine Titanummantelung Tu vor Korrosionsangriffen geschützt ist. Die Bürste Br besteht beispielsweise aus Kupfer, während sich für das Metallband Mb und die Kontaktfedern Kfo und Kfu Titan als Werkstoff bewährt hat.

Im Bereich eines Schlitzes Sz ist auf der Innenseite einer Seitenwand Sw eine Isolierwand Iw angebracht, welche insbesondere die im Schlitz Sz entlanggeführten oberen Kontaktfedern Kfo abschirmt und eine Beeinträchtigung der kathodischen Kontaktierung der Leiterplatten Lp durch unerwünschte Metallabscheidungen auf den Kontaktflächen verhindert.

Weitere Einzelheiten über das Durchkontaktieren und Galvanisieren von Leiterplatten Lp in einer Horizontal-Durchlaufanlage gehen aus der eingangs erwähnten EP-A-0 254 962 hervor.

## Patentansprüche

1. Galvanisiereinrichtung für im horizontalen Durchlauf zu behandelnde plattenförmige Werkstücke, insbesondere Leiterplatten, mit mindestens einem seitlich der Durchlaufbahn angeordneten endlosen Trieb (7), welcher die Seitenränder der Werkstücke erfassende und in Durchlaufrichtung (Pf1) verfahrbare Transport- und Kontaktierorgane (TKO) trägt, **dadurch gekennzeichnet,**
daß die Transport- und Kontaktierorgane (TKO) an einem endlos umlaufenden flexiblen Metallband (Mb) befestigt sind, dessen den Werkstücken zugewandte Seitenfläche oberhalb und unterhalb der Transport- und Kontaktierorgane (TKO) auf sich in Durchlaufrichtung (Pf1) erstreckenden Führungs- und Abdichtelementen (FAE) gleitet, wobei die Führungs- und Abdichtelemente (FAE) in eine Seitenwand (Sw) der Galvanisierzelle (Gz) integriert sind.

2. Galvanisiereinrichtung nach Anspruch 1,
**dadurch gekennzeichnet,**
daß zu beiden Seiten der Durchlaufbahn (Pf1) jeweils mindestens ein endloser Trieb (T) angeordnet ist.

3. Galvanisiereinrichtung nach Anspruch 1 oder 2,
**dadurch gekennzeichnet,**
daß in das Metallband (Mb) eine Transportperforation (Tp) eingebracht ist.

4. Galvanisiereinrichtung nach einem der vorhergehenden Ansprüche,
**dadurch gekennzeichnet,**
daß das Metallband (Mb) aus Titan besteht.

5. Galvanisiereinrichtung nach einem der vorhergehenden Ansprüche,
**dadurch gekennzeichnet,**
daß als Transport- und Kontaktierorgane (TKO) mehrere im Abstand zueinander am Metallband (Mb) befestigte Kontaktfederpaare vorgesehen sind, deren einander gegenüberliegende Kontaktfedern (Kfo, Kfu) federnd die Seitenränder der Werkstücke zwischen sich aufnehmen.

6. Galvanisiereinrichtung nach einem der vorhergehenden Ansprüche,
**dadurch gekennzeichnet,**
daß auf der den Werkstücken gegenüberliegenden Seite des Metallbandes (Mb) eine Stromschiene (Ss) angeordnet ist, die Kontaktmittel zur Schleifkontaktierung des Metallbandes (Mb) trägt.

7. Galvanisiereinrichtung nach Anspruch 6,
**dadurch gekennzeichnet,**
daß die Stromschiene (Ss) aus einem titanummantelten Kupferleiter (Kl) bestehen.

8. Galvanisiereinrichtung nach einem der vorhergehenden Ansprüche,
**dadurch gekennzeichnet,**
daß die Transport- und Kontaktierorgane (TKO) durch eine auf der Innenseite der Seitenwand (Sw) angeordnete Isolierwand (Iw) abgeschirmt sind.

## Claims

1. Electroplating apparatus for panel-type work-pieces, in particular printed circuit boards, to be treated while being conveyed horizontally, comprising at least one endless drive (7) which is disposed at the side of the conveyance path and which carries conveyance and connection devices (TKO) which engage the side edges of the workpieces and are capable of conveying them in the conveyance direction (Pf1), characterised in that the conveyance and connecting devices (TKO) are mounted on an endlessly circulating, flexible metal belt (Mb) whose side surface facing the workpieces slides above and below the conveyance and connecting devices (TKO) on guiding and sealing elements (FAE) extending in the conveyance direction (Pf1), the guiding and sealing elements (FAE) being built into a side wall (Sw) of the electroplating cell (Gz).

2. Electroplating apparatus according to Claim 1, characterised in that at least one endless drive (T) is disposed in each case on either side of the conveyance path (Pf1).

3. Electroplating apparatus according to Claim 1 or 2, characterised in that a conveyance perforation (Tp) is introduced into the metal belt (Mb).

4. Electroplating apparatus according to one of the preceding claims, characterised in that the metal belt (Mb) is composed of titanium.

5. Electroplating apparatus according to one of the preceding claims, characterised in that a plurality of contact spring pairs which are mounted at a distance from one another on the metal belt (Mb) and whose mutually opposite contact springs (Kfo, Kfu) resiliently receive the side edges of the workpieces between them are provided as conveyance and connecting devices (TKO).

6. Electroplating apparatus according to one of the preceding claims, characterised in that a current bar (Ss) which carries contact means for making a sliding connection to the metal belt (Mb) is disposed on the side of the metal belt (Mb) opposite the workpieces.

7. Electroplating apparatus according to Claim 6, characterised in that the current bar (Ss) is composed of a titanium-sheathed copper conductor (Kl).

8. Electroplating apparatus according to one of the preceding claims, characterised in that the conveyance and connecting devices (TKO) are screened by an insulating wall (Iw) disposed on the inside of the side wall (Sw).

## Revendications

1. Installation de galvanisation pour des pièces en forme de plaques, notamment des plaquettes de circuits imprimés, à traiter pendant leur déplacement horizontal, comportant au moins un transporteur sans fin (7) qui est placé sur le côté de la voie de déplacement et qui porte des organes d'établissement de contact et des organes de transport (TKO) détectant les côtés latéraux des pièces à traiter et susceptibles de se déplacer dans la direction du déplacement (Pf1),
caractérisée en ce que,
les organes de transport et les organes d'établissement de contact (TKO) sont fixés à une bande sans fin, métallique et flexible (Mb), dont la surface latérale voisine des pièces à traiter glisse, au-dessus et en-dessous des organes de transport et des organes d'établissement de contact (PKO), sur des éléments de guidage et d'étanchéification (FAE) qui s'étendent dans la direction de déplacement (Pf1), les éléments de guidage et d'étanchéification (FAE) étant intégrés dans une paroi latérale (Sw) de la cellule de galvanisation (Gz).

2. Installation de galvanisation selon la revendication 1,
caractérisée en ce que,
au moins un transporteur sans fin (T) est placé respectivement des deux côtés de la voie de déplacement (Tf1).

3. Installation de galvanisation selon la revendication 1 ou 2,
caractérisée en ce que,
une perforation de transport (Tp) est ménagée dans la bande métallique (Mb).

4. Installation de galvanisation selon l'une des revendications précédentes,
caractérisée en ce que,
la bande métallique (Mb) est en titane.

5. Installation de galvanisation selon l'une des revendications précédentes,
caractérisée en ce que,
il est prévu, comme organe de transport et d'établissement de contact (TKO), plusieurs couples de ressorts de contact fixés à distance les uns des autres à la bande métallique (Mb), et dont les ressorts de contact (Kfo, Kfu) situés les uns en face des autres, recoivent élastiquement entre eux les bords latéraux des pièces à traiter.

6. Installation de galvanisation selon l'une des revendications précédentes,
caractérisée en ce que,
sur la partie de la bande métallique (Mb) située en face des pièces à traiter, est disposée une barre conductrice (Ss) qui porte des moyens de contact pour l'établissement de contacts par frottement de la bande métallique (Mb).

7. Installation de galvanisation selon la revendication 6,
caractérisée en ce que,
la barre conductrice (Ss) est constituée d'un conducteur en cuivre enrobé de titane.

8. Installation de galvanisation selon l'une des revendications précédentes,
caractérisée en ce que,
les organes de transport et les organes d'établissement de contacts (TKO) sont protégés par une paroi isolante (Iw) disposée sur la face intérieure de la paroi latérale (Sw).
